# EUROPÄISCHE PATENTSCHRIFT

(11) **EP 1 086 289 B1**
(45) Veröffentlichungstag und Bekanntmachung des Hinweises auf die Patenterteilung: **16.06.2004**
(21) Anmeldenummer: 00909071.3
(22) Anmeldetag: 03.01.2000
(51) Int. Cl.: E06B 3/54

(54) **BEFESTIGUNGSVORRICHTUNG FÜR EINE GLASPLATTE AN EINER GEBÄUDESEITIGEN HALTERUNG**
DEVICE FOR FIXING A GLASS PANEL TO A SUPPORT AT THE SIDE OF A BUILDING
DISPOSITIF DE FIXATION D'UNE PLAQUE DE VERRE SUR UN SUPPORT PLACE DU COTE D'UN BATIMENT

(30) Priorität: 06.04.1999 DE 19915193
(43) Veröffentlichungstag der Anmeldung: 28.03.2001
(73) Patentinhaber: DORMA GmbH + Co. KG, 58256 Ennepetal (DE)
(72) Erfinder: ELMER, Hubert, A-6065 Thaur (AT); LEITGEB, Peter, A-6165 Telfes (AT)
(86) Internationale Anmeldenummer: PCT/EP2000/000004
(87) Internationale Veröffentlichungsnummer: WO 2000/060207

(56) Entgegenhaltungen:
- EP-A- 0 784 129
- DE-A- 3 927 653
- DE-A- 4 400 979
- DE-A- 4 445 724
- DE-A- 19 519 526
- DE-A- 19 519 527
- DE-A- 19 528 489

## Beschreibung

Die Erfindung betrifft eine Befestigungsvorrichtung für eine Glasplatte an einer gebäudeseitigen Halterung mit einem außenseitigen und einem innenseitigen, die Glasplatte zwischen sich einspannenden Klemmelement und einer raumgelenkigen Abstützung der Befestigungsvorrichtung an dem innenseitigen Klemmelement.

Durch die DE 195 19 527 A ist eine Vorrichtung der eingangs genannten Gattung bekannt geworden, bei der ein mit der gebäudeseitigen Halterung verbundener Träger an einem gebäudeinnenseitigen Klemmelement abgestützt ist. Die Abstützung erfolgt mittels eines in einer Lagerkammer des Klemmelementes in Achsrichtung des Trägers elastisch nachgiebig gelagerten Lagerkopfes des Trägers, wobei der Lagerkopf zusätzlich mit seitlichem Spiel in der Lagerkammer gelagert ist, um ein Verschieben des Trägers bzw. seines Lagerkopfes parallel zur Ebene der Glasplatte bei Einwirkung von Winddruck zu ermöglichen. Die elastische Nachgiebigkeit des Lagerkopfes wird durch Tellerfedern oder ein dauerelastisches Material bewirkt, dessen Anordnung in der Lagerkammer ständig eine Rückstellkraft auf den Träger bzw. die Glasscheibe im Sinne einer Positionierung des Trägers orthogonal zur Glasscheibe bewirkt, was letztlich die Einleitung von Spannungen in die Glasscheibe zur Folge hat. Außerdem können größere Toleranzen zwischen der Bohrung in der Glasscheibe und dem Anschlußpunkt an der gebäudeseitigen Halterung nicht ausgeglichen werden.

Die DE 44 00 979 A1 offenbart ebenfalls eine gattungsgemäße Vorrichtung, bei der das gebäudeinnenseitige Klemmelement (Aufnahmelager) an der der Halterung zugewandten Mantelfläche eine kugelige Oberfläche aufweist, an der ein Ausgleichsteil mit komplementärer Kugelkalottenfläche anliegt. Das Klemmelement besitzt eine Durchgangsbohrung für die Aufnahme der die Klemmelemente verbindenden Klemmschraube und einer ein Unterlegteil und das Ausgleichsteil durchfassende und in das Klemmelement einfassenden Halteschraube. Mit der bekannten Vorrichtung können Bautoleranzen zwischen der Bohrung in einer Glasscheibe und einer Unterkonstruktion (Halterung) ausgeglichen werden, eine federnd elastische Abstützung der Scheibe an der Halterung nach erfolgter Montage ist nicht vorgesehen.

Eine ähnliche Vorrichtung beschreibt die DE 44 45 724 A1, bei der das gebäudeinnenseitige Klemmelement an seiner der Halterung zugewandten Mantelfläche eine kugelige Oberfläche aufweist, an der ein Schwenklager eines Befestigungsteiles seiner Komplementärfläche anliegt, wobei das Schwenklager mit seitlichem Spiel in einer Überwurfmutter gehalten ist. Nach erfolgter Montage ist auch hier eine Relativbewegung der Scheibe gegenüber dem Befestigungsteil nicht mehr möglich.

Femer ist aus der EP 0 784 129 A1 eine Abstützung einer Befestigungsschraube an einer Halterung bekannt, bei der eine Platte der Halterung zwischen zwei plankonvexen Linsen festgelegt ist, die mit ihren Planflächen mittelbar an der Platte anliegen, wobei eine Linse mit ihrer konvexen Fläche an einem gebäudeinnenseitigen Klemmelement und die andere Linse mittelbar an einer die Befestigungsschraube aufnehmenden Mutter anliegt.

Bei der Befestigung von hochempfindlichen Glasplatten, beispielsweise in Verbindung mit Siliciumscheiben für die fotovoltäre Stromerzeugung genügen die vorbekannten Befestigungsvorrichtungen den an sie gestellten Anforderungen nicht. Bereits bei geringem Winddruck bzw. bei relativ geringen Verformungen aufgrund von Wärmeeinleitung kommt es zum Bruch der Siliciumelemente und damit zum Verlust des bestimmungsgemäßen Zweckes der Glasplatte.

Aufgabe der Erfindung ist es, eine Befestigungsvorrichtung der eingangs genannten Gattung dahingehend zu verbessern, daß zum einen eine spannungsfreie Anpassung der Befestigungsvorrichtung unter Berücksichtigung auch größerer Bautoleranzen bei der Montage möglich ist, daß zum anderen nach erfolgter Montage zwischen der Befestigungsvorrichtung und der Glasplatte eine ausreichende Elastizität verbleibt, um Winddruck oder Wärmespannungen ohne Einleitung von Spannungen in die Glasplatte von der Befestigungsvorrichtung aufnehmen zu können.

Die Erfindung löst die gestellte Aufgabe durch die Lehre nach Anspruch 1.

Hiemach weist ein innenseitiges Klemmelement nach seiner der Glasplatte abgewandten Glasfläche eine durch ein dauerelastisches Federglied gebildete kegelige oder ballige Fläche auf, gegen die eine Komplementärfläche eines Innenmantels einer Überwurfglocke mit einstellbarer Vorspannung anstellbar ist, wobei zwischen der Überwurfglocke und einer Befestigungsschraube einerseits und einer Befestigungsschraube und der Halterung andererseits jeweils ein verstarrbares Raumgelenk angeordnet ist.

Nach der erfindungsgemäßen Lösung werden Winddruck und Wärmespannungen durch die elastische Abstützung der Überwurfglocke an dem innenseitigen Klemmelement aufgefangen, weil auch nach erfolgter Montage eine Relativbewegung der beiden Teile zueinander ohne die Einleitung von Rückstellkräften in die Glasplatte möglich ist. Dies ist gewährleistet durch die einstellbare Vorspannung zwischen Klemmelement und Überwurfglocke. Durch die mehrfache Untergliederung der Befestigungsvorrichtung durch mindestens zwei weitere Raumgelenke ist nicht nur eine gute Anpassungsmöglichkeit an größere Bautoleranzen gegeben; die einzelnen Gelenkpunkte der Raumgelenke bilden auch bei fester Verspannung nach der Montage gewissermaßen Knotenpunkte mit einer gewissen Eigenelastizität, die zusätzlich zur spannungsfreien Lagerung der Glasplatte beitragen.

Weitere Merkmale der Erfindung sind durch die Unteransprüche gekennzeichnet.

Das innenseitige Klemmelement kann nach einer Ausführungsform der Erfindung selbst an seiner der Glasplatte abgewandten Mantelfläche eine kegelige oder ballige Fläche aufweisen, prinzipiell kann die kegelige oder ballige Fläche auch bei planer Ausbildung des Klemmelementes durch das dauerelastische Federglied gemäß Anspruch 1 gebildet werden.

Ferner ist im innenseitigen Klemmelement eine ein Innengewinde aufweisende zentrische Durchgangsbohrung für die Aufnahme einer die Klemmelemente verbindende Klemmschraube und einer die Überwurfglocke mit dem innenseitigen Klemmelement verbindende Überwurfglocke-Einstellschraube vorgesehen, wobei in Ausgestaltung der Erfindung das dauerelastische Federglied als dauerelastisches Kissen ausgebildet ist, welches zwischen der der Glasplatte zugewandten kegeligen oder balligen Fläche des innenseitigen Klemmelementes und der Komplementärfläche der Überwurfglocke angeordnet ist. Mittels der vorbeschriebenen Überwurfglocken-Einstellschraube kann das dauerelastische Kissen so eingespannt werden, daß nicht nur vom dauerelastischen Kissen selbst in die Glasplatte eingeleitete Spannungen aufgenommen werden können, sondern daß eine Relativverschiebung der Überwurfglocke gegenüber dem dauerelastischen Kissen möglich ist, so daß die Glasplatte völlig spannungsfrei gelagert ist.

Nach einem besonderen Merkmal der Erfindung weist die Überwurfglocke an ihrer der Halterung zugewandten Seite einen mit einem Außengewinde. versehenen zylindrischen Fortsatz auf, zwischen dem und der Überwurfglocke im Bereich des Bodentiefsten der Überwurfglocke ein nach innen gerichteter Flansch für die Abstützung des Schraubenkopfes der Überwurfglocken-Einstellschraube ausgebildet ist. Dabei ermöglicht ein zwischen dem Flansch und einem Schaft der Überwurfglocken -Einstellschraube vorgesehenes Spiel die Anordnung einer als Linse ausgebildeten Scheibe zwischen dem Flansch und dem Schraubenkopf der Überwurfglocken-Einstellschraube derart, daß der Schaft der Überwurfglokken-Einstellschraube gegenüber der Überwurfglocke eine Pendelbewegung ausüben kann. Diese Pendelbewegung wird begünstigt, wenn die Anlagefläche des Flansches und die Komplementärfläche der Linse kegelig oder ballig verlaufend ausgebildet sind. Es hat sich als zweckmäßig erwiesen, hierfür eine nicht metallische, beispielsweise aus einem gleitfähigen Hartgummi bestehende Linse zu verwenden. Auf diese Weise wird praktisch ein zusätzliches Raumgelenk zwischen der Überwurfglocke und dem innenseitigen Klemmelement und damit der Glasplatte geschaffen.

Ein weiteres Raumgelenk besteht darin, daß die gegen die Halterung gerichtete Stirnfläche des Fortsatzes der Überwurfglocke konkavlinsenförmig gekrümmt ist, wobei eine das Außengewinde des Fortsatzes der Überwurfglocke überfassende topfartige Überwurfmutter eine innere Topfbodenfläche aufweist, die entsprechend gegensinnig zur Stirnfläche des Fortsatzes der Überwurfglocke gekrümmt ist, so daß zwischen der Stirnfläche des Fortsatzes der Überwurfglocke und der Topfbodenfläche der Überwurfmutter zwei mit ihren Planflächen aneinander liegende konvexe Linsen gelagert sein können. Mittels der vorbeschriebenen Überwurfmutter kann das vorbeschriebene Raumgelenk nach erfolgter Montage verstarrt werden. In einer vorteilhaften Ausgestaltungsform der Erfindung ist die der Topfbodenfläche der Überwurfmutter anliegende plankonvexe Linse Bestandteil einer die Befestigungsschraube aufnehmenden Mutter, wodurch die Möglichkeit gegeben ist, die Befestigungsschaube mehr oder weniger tief in die Mutter zum Zwecke einer gewünschten Verkürzung oder Verlängerung der ganzen Befestigungsvorrichtung einzuschrauben. Zur Erzielung des vorgenannten Raumgelenkes ist der Schaft der Mutter so dimensioniert, daß er eine Bohrung im Topfboden der Überwurfmutter mit Spiel durchfasst.

Ein weiteres Raumgelenk kann in an sich bekannter Weise im Bereich der unmittelbaren Verbindung der Befestigungsschraube mit der Halterung dadurch realisiert werden, daß die Befestigungsschraube eine Bohrung in der Halterung mit Spiel durchfasst und die Halterung zwischen einer Mutter und einer Kontermutter festgelegt ist, wobei zwischen der Mutter und der Kontermutter einerseits und der Halterung andererseits jeweils eine plankonvexe, mit ihrer Planfläche der Halterung anliegende Linse vorgesehen ist und die Mutter und Kontermutter zur Linse komplementäre Anlageflächen aufweisen. Auch hierbei handelt es sich bei der Montage um ein einstellbares und anpassbares und nach erfolgter Montage verstarrbares Raumgelenk, wobei zwischen dem letztgenannten, den Anschluß an die Halterung bildenden Raumgelenk und dem durch die Überwurfglocke und die Überwurfmutter gebildeten Raumgelenk eine Distanzhülse vorgesehen sein kann.

Die Ausbildung des die Glasplatte einspannenden, gebäudeaußenseitigen Klemmelementes kann grundsätzlich beliebig sein; sie kann in an sich bekannter Weise als Klemmteller oder als Senkschraube ausgebildet sein, ohne die mit der Erfindung erzielbare spannungsfreie Befestigung der Glasplatte zu beeinflussen.

Die Erfindung wird nachfolgend anhand verschiedener Ausführungsbeispiele näher erläutert. Es zeigen:
- Figur 1:: Einen Querschnitt durch eine Befestigungsvorrichtung.
- Figur 2:: Den Querschnitt nach Figur 1 bei gegenüber der Halterung abgewinkelter Glasplatte.
- Figur 3:: Den Querschnitt nach Figur 1 mit geändertem außenseitigen Klemmelement.

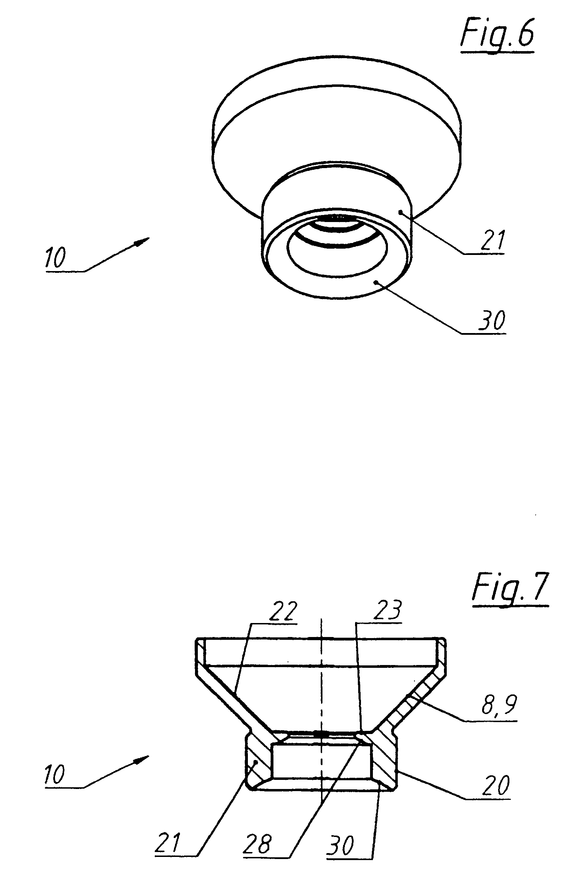

Figuren 4 - 13: Einzelheiten des innenseitigen Klemmelementes, der Überwurfglocke, der der Schraubenglocke der Überwurfglocken-Einstellschraube anliegenden Linse, der die Befestigungsschraube aufnehmenden Mutter und der Überwurfmutter, jeweils in perspektivischer Ansicht und im Querschnitt.

Gleiche Bauteile werden in den einzelnen Zeichnungen - soweit erforderlich- mit gleichen Bezugszahlen belegt.

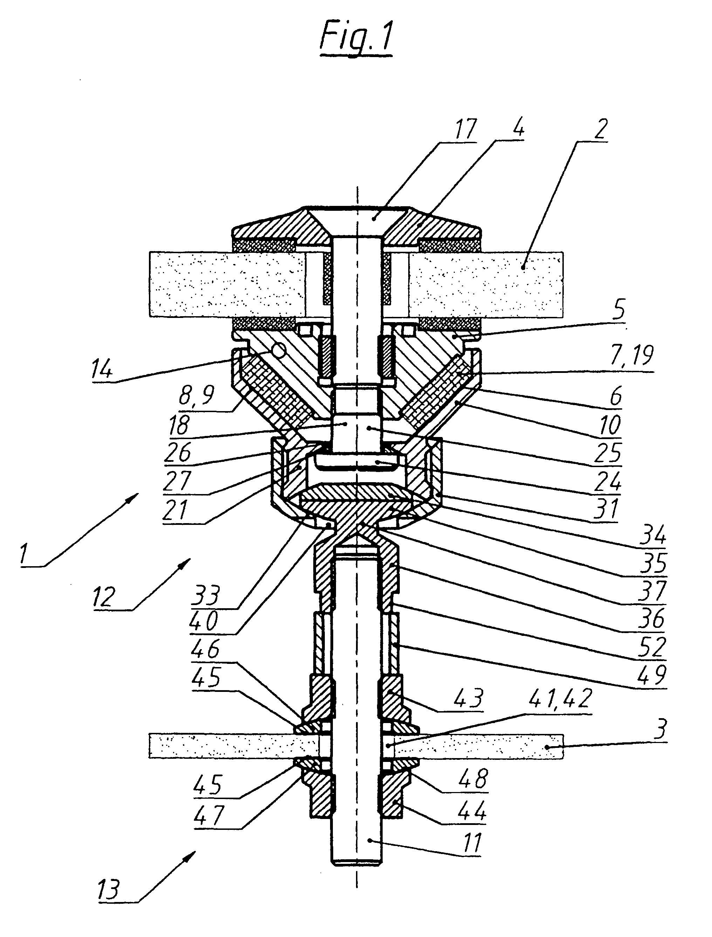

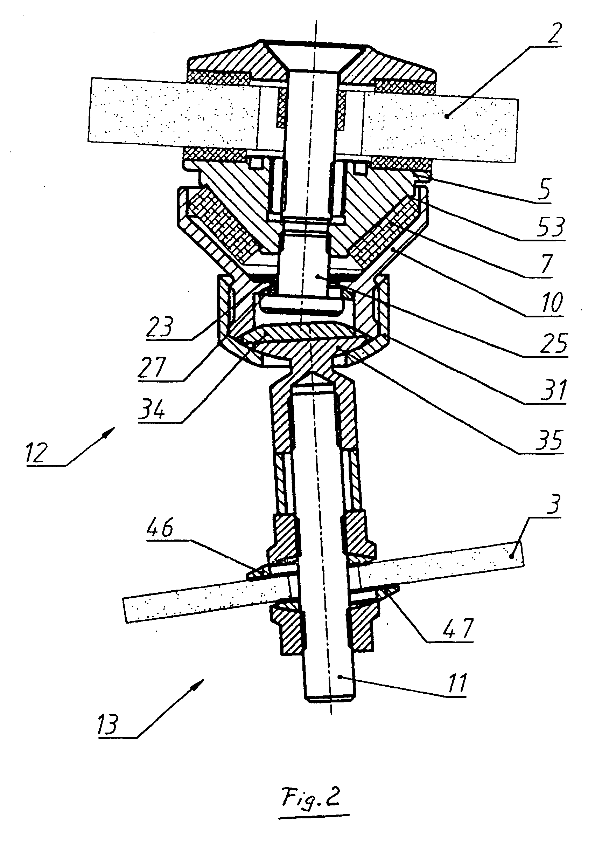

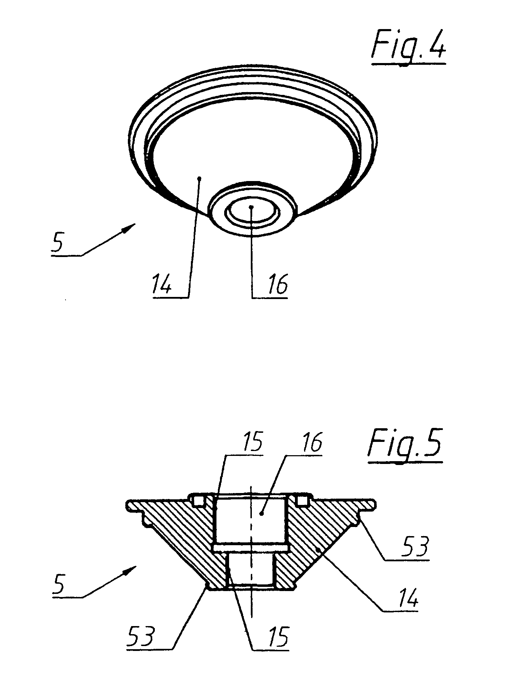

Eine Befestigungsvorrichtung 1 gemäß Figur 1 besitzt zwei Klemmelemente 4 und 5, zwischen denen eine Glasplatte 2 eingespannt ist. Der in bekannter Weise angeordnete und aus der Zeichnung ersichtlich Glasschutz ist nicht näher bezeichnet. Das innenseitige Klemmelement 5 besitzt im Ausführungsbeispiel eine kegelige Mantelfläche 14, an der ein sich an einem Vorsprung 53 abstützendes als dauerelastisches Kissen 19 ausgebildetes dauerelastisches Federglied anliegt, das praktisch damit die eigentliche Mantelfläche 6 des Klemmelementes 5 bildet. An dieser Mantelfläche 6 liegt ein Innenmantel 9 einer Überwurfglocke 10 mit einer Komplementärfläche 8 an. Eine Klemmschraube 17 durchfasst eine Durchgangsbohrung 16 (siehe Figuren 4 und 5) des Klemmelementes 5 und verbindet die beiden Klemmelemente 4 und 5. Die Durchgangsbohrung 16 weist zu diesem Zweck ein Innengewinde 15 auf. In das gleiche Innengewinde 15 faßt eine Überwurfglocken-Einstellschraube 18 ein, deren Schraubenkopf 24 sich an einem Flansch 23 eines zylindrischen Fortsatzes 21 der Überwurfglocke 10 abstützt. Zwischen dem Flansch 23 und dem Schraubenkopf 24 ist eine vorzugsweise elastische Linse 27 vorgesehen, welche sich an einer Anlagefläche 28 des Flansches 23 abstützt, so daß an dieser Stelle ein Raumgelenk im Rahmen eines Spiels 26, wie aus Figur 2 ersichtlich, gebildet wird. Die Linse 27 besitzt hierzu eine Komplementärfläche 29. Der vom Bereich des Bodentiefsten 22 ausgehende zylindrische Fortsatz 21 der Überwurfglocke 10 weist eine gegen die Halterung 3 gerichtete Stirnfläche 30 auf, die konkav gekrümmt ist. Eine entsprechende gegensinnige Krümmung besitzt eine innere Topfbodenfläche 32 einer Überwurfmutter 31, so daß zwischen der Stirnfläche 30 des Fortsatzes 21 und einem Topfboden 39 der Überwurfmutter 31 zwei Linsen 34 und 35 angeordnet werden können, deren Planflächen 33 aufeinander liegen und von denen eine lose Linse 34 mit ihrer konvexen Fläche an der Stimfläche 30 des Fortsatzes 21 anliegt, während die zweite Linse 35 fester Bestandteil einer eine Befestigungsschraube 11 aufnehmenden Mutter 36 ist und sich mit ihrer konvexen Fläche am Topfboden 39 abstützt. Die Mutter 36 besitzt einen Schaft 37, welcher eine Bohrung 38 in der Überwurfmutter 31 mit Spiel 40 durchfasst.

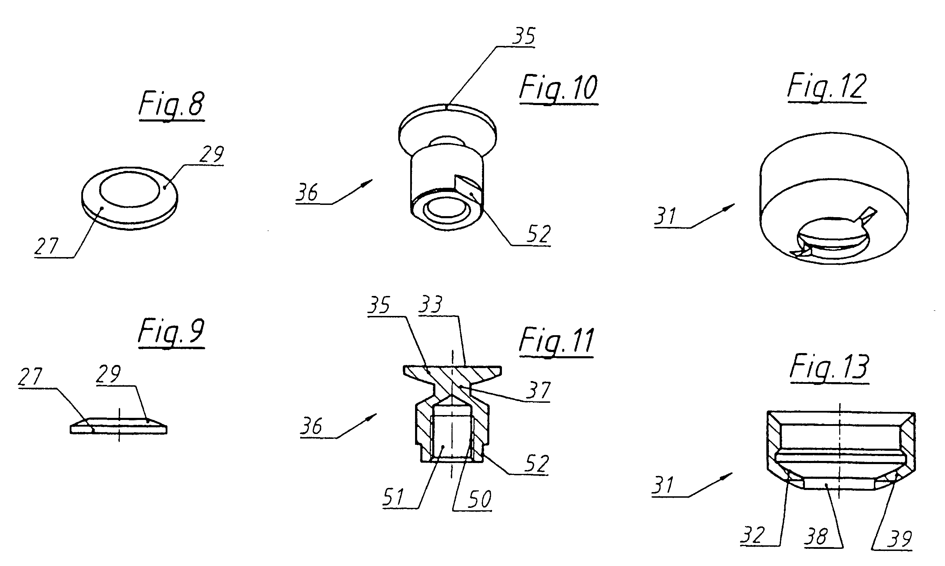

Figur 1 läßt erkennen, daß beim Aufschrauben der Überwurfmutter 31 auf die Überwurfglocke 10 mittels eines Außengewindes 20 im Bereich des Fortsatzes 21 ein allgemein mit 12 bezeichnetes und durch die beiden Linsen 34 und 35 gebildete Raumgelenk verstarrt werden kann. Die Mutter 36 (siehe Figur 10 und 11) besitzt eine Sackbohrung 51 mit einem Innengewinde 50, in das die Befestigungsschraube 11 eingeschraubt werden kann, wobei am Außenmantel der Mutter 36 Schlüsselflächen 52 vorgesehen sind. Figur 1 zeigt ferner, daß sich im Ausführungsbeispiel an die Mutter 36 eine Distanzhülse 49 anschließt, die sich ihrerseits gegen eine die Halterung 3 einspannende Mutter 43 abstützt. Zwischen der Mutter 43 und einer Kontermutter 44 sind Linsen 46 und 47 vorgesehen, die an komplementären Anlageflächen 48 der Mutter 43 bzw. Kontermutter 44 anliegen. Planflächen 45 der Linsen 46 und 47 liegen unmittelbar an der Halterung 3 an. Da eine Befestigungsschraube 11 eine Bohrung 41 der Halterung 3 mit Spiel 42 durchfasst, ist auch hier ein mit 13 bezeichnetes Raumgelenk gebildet, mit dem Bautoleranzen ausgeglichen werden können.

Figur 2 zeigt die mögliche Schräglage der Glasplatte 2 gegenüber der Halterung 3 bei entsprechender Einstellung der Raumgelenke 12 und 13, sowie entsprechender Abwinckelung im Bereich eines Schaftes 25 der Überwurfglocken-Einstellschraube 18 gegenüber der Überwurfglocke 10 einerseits und gegenüber der Überwurfmutter 31 andererseits. Es ist ersichtlich, daß eine Verschiebung der Überwurfglocke 10 gegenüber einem dauerelastischen Federglied 7 stattgefunden hat. Das heißt, daß an dieser Stelle ein nicht verstarrbares Raumgelenk gebildet ist. Das dauerelastische Federglied 7 hat sich in seiner Lage relativ zum Klemmelement 5 in Folge der Abstützung an den Vorsprüngen 53 nicht verändert.

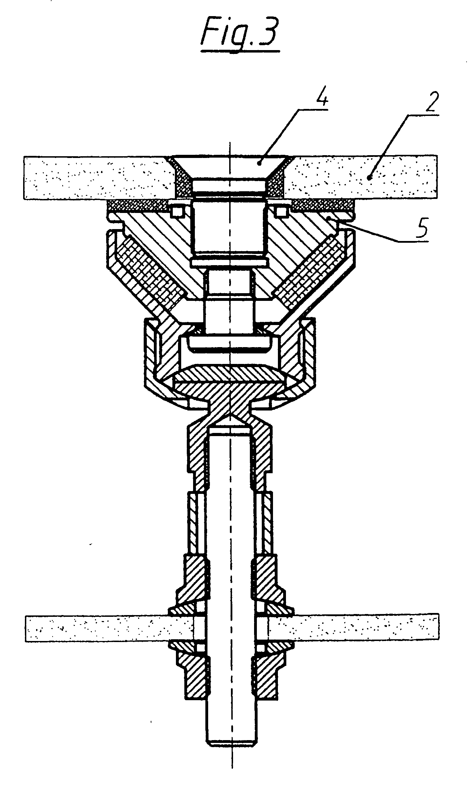

Das Ausführungsbeispiel nach Figur 3 entspricht in seinen wesentlichen Bauteilen dem Ausführungsbeispiel nach Figur 1, wobei im Gegensatz zu Figur 1 das außenseitige Klemmelement 4 als Senkschraube ausgebildet ist.

Die vorbeschriebene Befestigungsvorrichtung ist somit geeignet, die Elastizität der Glasplatten 2 zu erhalten, da sie die Bewegungsfreiheit dieser nicht einschränkt und somit zu einer Kraftneutralisierung führt. Die erfindungsgemäße Befestigungsvorrichtung bedeutet Anpassung an die Umgebungsvorgaben und nicht eine Rigidität des Baustoffes Glas, die zwangsläufig zu einer Zerstörung führt, wie es beim aufgezeigten Stand der Technik der Fall ist.

Für jegliche Anwendungen von punktförmig aufgehängten Glasplatten, ob innen oder außen, ob mit oder ohne voltaischen Elementen, eignet sich die Befestigungsvorrichtung zur spannungsfreien Montage und auch zum spannungsfreien Dauerbetrieb.

### Bezugszeichen

- 1: Befestigungsvorrichtung
- 2: Glasplatte
- 3: gebäudeseitige Halterung
- 4: Klemmelement
- 5: Klemmelement
- 6: Mantelfläche
- 7: dauerelastisches Federglied
- 8: Komplementärfläche
- 9: Innenmantel
- 10: Überwurfglocke
- 11: Befestigungsschraube
- 12: Raumgelenk
- 13: Raumgelenk
- 14: Mantelfläche
- 15: Innengewinde
- 16: Durchgangsbohrung
- 17: Klemmschraube
- 18: Überwurfglocken-Einstellschraube
- 19: dauerelastisches Kissen
- 20: Außengewinde
- 21: zylindrischer Fortsatz
- 22: Bodentiefstes
- 23: Flansch
- 24: Schraubenkopf
- 25: Schaft
- 26: Spiel
- 27: Linse
- 28: Anlagefläche
- 29: Komplementärfläche
- 30: Stirnfläche
- 31: Überwurfmutter
- 32: innere Topfbodenfläche
- 33: Planfläche
- 34: Linse
- 35: Linse
- 36: Mutter
- 37: Schaft
- 38: Bohrung
- 39: Topfboden
- 40: Spiel
- 41: Bohrung
- 42: Spiel
- 43: Mutter
- 44: Kontermutter
- 45: Planflächen
- 46: Linse
- 47: Linse
- 48: komplementäre Anlagefläche
- 49: Distanzhülse
- 50: Innengewinde
- 51: Sackbohrung
- 52: Schlüsselflächen
- 53: Vorsprung

## Patentansprüche

1. Befestigungsvorrichtung für eine Glasplatte an einer gebäudeseitigen Halterung mit einem außenseitigen und einem innenseitigen, die Glasplatte zwischen sich einspannenden Klemmelement und einer raumgelenkigen Abstützung der Befestigungsvorrichtung an dem innenseitigen Klemmelement, **dadurch gekennzeichnet, daß** das innenseitige Klemmelement (5) an seiner der Glasplatte (2) abgewandten Mantelfläche(6) eine durch ein dauerelastisches Federglied (7) gebildete kegelige oder ballige Mantelfläche (6) aufweist, gegen die eine Komplementärfläche (8) eines Innenmantels (9) einer Überwurfglocke (10) mit einstellbarer Vorspannung anstellbar ist, und daß zwischen der Überwurfglocke (10) und einer Befestigungsschraube (11) und der Halterung (3) jeweils ein verstarrbares Raumgelenk (12, 13) angeordnet ist.

2. Befestigungsvorrichtung nach Anspruch 1, **dadurch gekennzeichnet, daß** das innenseitige Klemmelement (5) an seiner der Glasplatte (2) abgewandten Mantelfläche (14) eine kegelige oder ballige Mantelfläche (14) aufweist.

3. Befestigungsvorrichtung nach Anspruch 1 und 2, **dadurch gekennzeichnet, daß** das innenseitige Klemmelement (5) eine ein Innengewinde (15) aufweisende zentrische Durchgangsbohrung (16) für die Aufnahme einer die Klemmelemente (4, 5) verbindenden Klemmschraube (17) und einer die Überwurfglocke (10) mit dem innenseitigen Klemmelement (5) verbindende Überwurfglokken-Einstellschraube (18) aufweist.

4. Befestigungsvorrichtung nach Anspruch 1 und 2, **dadurch gekennzeichnet, daß** zwischen der der Glasplatte (2) abgewandten kegeligen oder balligen Fläche des innenseitigen Klemmelementes (5) und der Komplementärfläche (8) der Überwurfglocke (10) ein dauerelastisches Kissen (9) angeordnet ist.

5. Befestigungsvorrichtung nach einem der Ansprüche 1 bis 4, **dadurch gekennzeichnet, daß** die Überwurfglocke (10) an ihrer der Halterung (3) zugewandten Seite einen mit einem Außengewinde (20) versehenen zylindrischen Fortsatz (21) aufweist, zwischen dem und der Überwurflocke (10) im Bereich des Bodentiefsten (22) der Überwurfglocke (10) ein nach innen gerichteter Flansch (23) für die Abstützung des Schraubenkopfes (24) der Überwurfglocken- Einstellschraube (18) ausgebildet ist.

6. Befestigungsvorrichtung nach Anspruch 5, **dadurch gekennzeichnet, daß** zwischen dem Flansch (23) und einem Schaft (25) der Überwurfglocken-Einstellschraube ein Spiel (26) vorgesehen ist.

7. Befestigungsvorrichtung nach Anspruch 5 und 6, **dadurch gekennzeichnet, daß** zwischen dem Flansch (23) und dem Schraubenkopf (24) der Überwurfglocken-Einstellschraube (18) eine Linse (27) angeordnet ist.

8. Befestigungsvorrichtung nach Anspruch 5 bis 7, **dadurch gekennzeichnet, daß** eine Anlagefläche (28) des Flansches (23) und eine Komplementärfläche (29) der Linse (27) kegelig oder ballig verlaufend ausgebildet sind.

9. Befestigungsvorrichtung nach Anspruch 5, **dadurch gekennzeichnet, daß** eine gegen die Halterung (3) gerichtete Stirnfläche (30) des Fortsatzes (21) der Überwurfglocke (10) konkav linsenförmig gekrümmt ist.

10. Befestigungsvorrichtung nach einem der Ansprüche 1 bis 9, **gekennzeichnet durch** eine das Außengewinde (20) des Fortsatzes (21) der Überwurfglocke (10) überfassende topfartige Überwurfmutter (31), deren innere Topfbodenfläche (32) gegensinnnig zur Stirnfläche (30) des Fortsatzes (21) der Überwurfglocke (10) gekrümmt ist.

11. Befestigungsvorrichtung nach Anspruch 10, **dadurch gekennzeichnet, daß** zwischen der Stirnfläche (30) des Fortsatzes (21) der Überwurfglocke (10) und der Topfbodenfläche (32) der Überwurfmutter (31) zwei mit ihren Planflächen (33) aneinander liegende, plankonvexe Linsen (34, 35) angeordnet sind.

12. Befestigungsvorrichtung nach Anspruch 11, **dadurch gekennzeichnet, daß** die der Topfbodenfläche (32) der Überwurfmutter (31) anliegende plankonvexe Linse (35) Bestandteil einer die Befestigungsschraube (11) aufnehmenden Mutter (36) ist.

13. Befestigungsvorrichtung nach Anspruch 12, **dadurch gekennzeichnet, daß** ein Schaft (37) der Mutter (36) eine Bohrung (38) im Topfboden (39) der Überwurfmutter (31) mit Spiel durchfasst.

14. Befestigungsvorrichtung nach einem der Ansprüche 1 bis 13, **dadurch gekennzeichnet, daß** die Befestigungsschraube (11) eine Bohrung (41) in der Halterung (3) mit Spiel (42) durchfasst und die Halterung (3) zwischen einer Mutter (43) und einer Kontermutter (44) festgelegt ist, wobei zwischen der Mutter (43) bzw. der Kontermutter (44) einerseits und der Halterung (3) andererseits jeweils eine plankonvexe, mit ihrer Planfläche (45) der Halterung anliegende Linse (46, 47) vorgesehen ist und die Mutter (43) und Kontermutter (44) zur Linse (46, 47) komplementäre Anlagefläche (48) aufweisen.

15. Befestigungsvorrichtung nach einem der Ansprüche 1 bis 14, **dadurch gekennzeichnet, daß** zwischen der die Befestigungsschraube (11) aufnehmenden Mutter (36) und der die Halterung (3) festlegende Mutter (43) eine Distanzhülse (49) angeordnet ist.

16. Befestigungsvorrichtung nach einem der Ansprüche 1 bis 15, **dadurch gekennzeichnet, daß** das außenseitige Klemmelement (4) als Klemmteller ausgebildet ist.

17. Befestigungsvorrichtung nach einem der Ansprüche 1 bis 15, **dadurch gekennzeichnet, daß** das außenseitige Klemmelement (4) als Senkschraube ausgebildet ist.

## Claims

1. An attachment device for a glass pane at a mounting fixed to a building structure with one outside and one inside clamping element fastening the glass pane in between and a three-dimensionally articulated support of the attachment device at the inside clamping element, **characterized in that** the inside clamping element (5), on the envelope surface (6) thereof, opposite to the glass pane (2), presents a conical or crowned envelope surface (6) formed by a permanently elastic spring member (7), against which surface a complementary surface (8) of an interior envelope (9) of a coupling bell (10) is adjustable with adaptable initial tension, and **in that** between the coupling bell (10) and an attachment bolt (11) and the mounting (3) respectively one three-dimensional articulation (12, 13), that can be stiffened, is arranged.

2. An attachment device according to claim 1, **characterized in that** the inside clamping element (5) presents on the envelope surface (14) thereof opposite to the glass pane (2) a conical or crowned envelope surface (14).

3. An attachment device according to claim 1 and 2, **characterized in that** the inside clamping element (5) presents a centrical through borehole (16) presenting a female thread (15) for the reception of a clamp screw (17) connecting the clamping elements (4, 5), and a coupling bell regulating screw (18) connecting the coupling bell (10) with the inside clamping element (5).

4. An attachment device according to claim 1 and 2, **characterized in that** a permanently elastic cushion (9) is arranged between the conical or crowned surface of the inside clamping element (5) located opposite to the glass pane (2) and the complementary surface (8) of the coupling bell (10).

5. An attachment device according to any of the claims 1 to 4, **characterized in that** the coupling bell (10) on the side thereof oriented towards the mounting (3) presents a cylindrical extension (21) having a male thread (20), between said extension and the coupling bell (10), in the area of the bottom (22) of the coupling bell (10), being formed an inwardly oriented flange (23) for the support of the screw head (24) of the coupling bell regulating screw (18).

6. An attachment device according to claim 5, **characterized in that** a play (26) is provided between the flange (23) and a shaft (25) of the coupling bell regulating screw.

7. An attachment device according to claim 5 and 6, **characterized in that** a lens (27) is disposed between the flange (23) and the screw head (24) of the coupling bell regulating screw (18).

8. An attachment device according to claim 5 to 7, **characterized in that** a locating face (28) of the flange (23) and a complementary surface (29) of the lens (27) is formed in a conical or crowned extending shape.

9. An attachment device according to claim 5, **characterized in that** a fore-part (30) of the extension (21) of the coupling bell (10) oriented towards the mounting (3) is curved in a concave lens-shape.

10. An attachment device according to any of the claims 1 to 9, **characterized by** a pot-like union nut (31) overlapping the male thread (20) of the extension (21) of the coupling bell (10), the inner pot bottom surface (32) of said nut being curved in the opposite direction with regard to the fore-part (30) of the extension (21) of the coupling bell (10).

11. An attachment device according to claim 10, **characterized in that**, between the fore-part (30) of the extension (21) of the coupling bell (10) and the pot bottom surface (32) of the union nut (31), two piano-convex lenses (34, 35) abutting each other with the flat surfaces (33) thereof are arranged.

12. An attachment device according to claim 11, **characterized in that** the plano-convex lens (35) abutting at the pot bottom surface (32) of the union nut (31) forms a component of a nut (36) accommodating the attachment bolt (11).

13. An attachment device according to claim 12, **characterized in that** a shaft (37) of the nut (36) passes with play through a borehole (38) in the pot bottom (39) of the union nut (31).

14. An attachment device according to any of the claims 1 to 13, **characterized in that** the attachment bolt (11) passes with play (42) through a borehole (41) in the mounting (3) and the mounting (3) is secured between a nut (43) and a counter nut (44), on the one hand between the nut (43) respectively the counter nut (44) and on the other hand the mounting (3), respectively one piano-convex lens (46, 47) being provided which, with the flat surface (45) thereof, abuts at the mounting, and the nut (43) and the counter nut (44) presenting a complementary locating face (48) with regard to the lens (46, 47).

15. An attachment device according to any of the claims 1 to 14, **characterized in that** a distance sleeve (49) is disposed between the nut (36) accommodating the attachment bolt (11) and the nut (43) securing the mounting (3).

16. An attachment device according to any of the claims 1 to 15, **characterized in that** the outside clamping element (4) is constituted as a clamping disc.

17. An attachment device according to any of the claims 1 to 15, **characterized in that** the outside clamping element (4) is constituted as a countersunk screw.

## Revendications

1. Dispositif de fixation pour un panneau en verre sur un support côté bâtiment avec un membre de serrage extérieur et un membre de serrage intérieur, serrant entre eux le panneau en verre et avec un élément d'appui articulé en trois dimensions pour le dispositif de fixation sur le membre de serrage intérieur, **caractérisé en ce que** le membre de serrage intérieur (5) présente, sur sa surface d'enveloppe (6) opposée au panneau en verre (2), une surface d'enveloppe (6) conique ou sphérique, formée par l'intermédiaire d'un membre à ressort (7) à élasticité permanente, contre laquelle une surface complémentaire (8) d'une enveloppe intérieure (9) d'une cloche d'accouplement (10) peut être serrée avec une précontrainte réglable, et **en ce que**, entre la cloche d'accouplement (10) et une vis de fixation (11) et le support (3), respectivement une articulation en trois dimensions (12, 13) que l'on peut rigidifier, est disposée.

2. Dispositif de fixation selon la revendication 1, **caractérisé en ce que** le membre de serrage intérieur (5) présente une surface d'enveloppe conique ou sphérique (14) sur sa surface d'enveloppe (14) opposée au panneau en verre (2).

3. Dispositif de fixation selon la revendication 1 et 2, **caractérisé en ce que en ce que** le membre de serrage intérieur (5) présente un alésage de passage central (16) présentant un taraudage (15) pour accommoder une vis de serrage (17) connectant les membres de serrage (4, 5), et une vis d'ajustement de la cloche d'accouplement (18), connectant la cloche d'accouplement (10) avec le membre de serrage intérieur (5).

4. Dispositif de fixation selon la revendication 1 et 2, **caractérisé en ce qu'**un coussin à élasticité permanente (9) est agencé entre la surface conique ou sphérique du membre de serrage intérieur (5), opposée au panneau en verre (2), et la surface complémentaire (8) de la cloche d'accouplement (10).

5. Dispositif de fixation selon l'une des revendications 1 à 4, **caractérisé en ce que** la cloche d'accouplement (10) présente, sur son côté orienté vers le support (3), un prolongement cylindrique (21) pourvu d'un filetage mâle (20), entre ledit prolongement et la cloche d'accouplement (10), dans la région la plus profonde du fond (22) de la cloche d'accouplement (10), étant formée une bride (23), orientée vers l'intérieur, pour le soutien de la tête de vis (24) de la vis d'ajustement de la cloche d'accouplement (18).

6. Dispositif de fixation selon la revendication 5, **caractérisé en ce qu'**un jeu (26) est prévu entre la bride (23) et une tige (25) de la vis d'ajustement de la cloche d'accouplement.

7. Dispositif de fixation selon la revendication 5 et 6, **caractérisé en ce qu'**une lentille (27) est agencée entre la bride (23) et la tête de vis (24) de la vis d'ajustement de la cloche d'accouplement (18).

8. Dispositif de fixation selon la revendication 5 à 7, **caractérisé en ce qu'**une surface d'appui (28) de la bride (23) et une surface complémentaire (29) de la lentille (27) sont formées de façon à s'étendre coniquement ou sphériquement.

9. Dispositif de fixation selon la revendication 5, **caractérisé en ce que**, orientée contre le support (3), une surface frontale (30) du prolongement (21) de la cloche d'accouplement (10) est courbée de façon concave lenticulaire.

10. Dispositif de fixation selon l'une des revendications 1 à 9, **caractérisé par** un écrou d'accouplement en forme de pot (31) enveloppant le filetage mâle (20) du prolongement (21) de la cloche d'accouplement (10), écrou dont une surface intérieure du fond en forme de pot (32) est courbée en sens inverse par rapport à la surface frontale (30) du prolongement (21) de la cloche d'accouplement (10).

11. Dispositif de fixation selon la revendication 10, **caractérisé en ce que**, entre la surface frontale (30) du prolongement (21) de la cloche d'accouplement (10) et la surface du fond en forme de pot (32) de l'écrou d'accouplement (31), les surfaces planes (33) de deux lentilles (34, 35) plan-convexes sont agencées de façon contiguë.

12. Dispositif de fixation selon la revendication 11, **caractérisé en ce que** la lentille (35) plan-convexe étant contiguë de la surface du fond en forme de pot (32) de l'écrou d'accouplement (31) fait partie d'un écrou (36) accommodant la vis de fixation (11).

13. Dispositif de fixation selon la revendication 12, **caractérisé en ce qu'**une tige (37) de l'écrou (36) passe avec jeu à travers un perçage (38) dans le fond du pot (39) de l'écrou d'accouplement (31).

14. Dispositif de fixation selon l'une des revendications 1 à 13, **caractérisé en ce que** la vis de fixation (11) passe avec jeu (42) à travers un perçage (41) dans le support (3) et le support (3) est fixé entre un écrou (43) et un contre-écrou (44), une lentille (46, 47) plan-convexe respectivement, dont la surface plane (45) est contiguë du support, étant prévue entre le écrou (43) respectivement le contre-écrou (44) d'une part et le support (3) d'autre part, et l'écrou (43) et le contre-écrou (44) présentant une surface d'appui (48) complémentaire à la lentille (46, 47).

15. Dispositif de fixation selon l'une des revendications 1 à 14, **caractérisé en ce qu'**une douille d'écartement (49) est agencée entre le écrou (36), accommodant la vis de fixation (11) et l'écrou (43) fixant le support (3).

16. Dispositif de fixation selon l'une des revendications 1 à 15, **caractérisé en ce que** le membre de serrage extérieur (4) est formé comme un disque de serrage.

17. Dispositif de fixation selon l'une des revendications 1 à 15, **caractérisé en ce que** le membre de serrage extérieur (4) est formé comme un boulon à tête fraisée.
